# EUROPEAN PATENT SPECIFICATION

(11) **EP 0 435 013 B1**
(45) Date of publication and mention of the grant of the patent: **07.02.1996**
(21) Application number: 90122944.3
(22) Date of filing: 30.11.1990
(51) Int. Cl.: G11C 7/00, G11C 8/00

(54) **Input signal redriver system for semiconductor modules**
Eingangssignalwiedergestaltungsanordnung für Halbleitermodule
Système de réadaptation de signal d'entrée pour modules à semi-conducteurs

(30) Priority: 27.12.1989 US 457470
(43) Date of publication of application: 03.07.1991
(73) Proprietor: International Business Machines Corporation, Armonk, N.Y. 10504 (US)
(72) Inventor: Ellis, Wayne F., Jericho, Vermont 05465 (US); Klink, Erich, W-7036 Schönaich (DE); Najmann, Kunt, W-7034 Gärtringen (DE)
(74) Representative: Schäfer, Wolfgang, Dipl.-Ing.

(56) References cited:
- EP-A- 0 325 078
- EP-A- 0 333 006

## Description

This invention relates to the packaging and assembly of semiconductor devices into functional units, and particularly to the packaging of pluralities of semiconductor devices having common input signal lines.

In the development of semiconductor packaging technology it has been the experience that succeeding generations of products of similar function, but having far greater density, are used to replace earlier production versions. One of the packaging constraints placed on the superseding product is a desire that a plurality of substantially identical semiconductor devices be mounted on a common carrier, be it a module or an integrated circuit card. Because of the increased capacitive loading encountered by the multiplication of circuit devices, input signal drivers originally designed for a single integrated circuit are required to drive several circuit devices. In fabricating semiconductor memory devices it is common to package a number of memory chips or modules on a single subassembly identified as a single in-line package (SIP) or a single in-line memory module (SIMM) in which all of the memory components share a plurality of signal lines. The total capacitive load to be driven can approach several nano-farads for a single net driver.

An additional problem associated with the application of signals to semiconductor devices in such packages is the presence of net switching delays resulting in degraded system performance. Increases in performance by higher density technologies may be overwhelmed by increases in net loading.

A common practice in situations where several integrated devices, such as memory modules, are required to be responsive to common input signals is to provide discrete logic signal driver modules in addition to functional logic or memory modules required by the application. For example, in a particular application, a computer system might be designed to have a memory capacity of 1 Megabyte of storage. This would typically be implemented by providing a memory card including nine (9) 1Mbit dynamic random access memory (DRAM) modules. Since the initial memory and the remainder of the system were designed simultaneously, digital signal drivers are performance matched to the DRAMs provided. That is, the circuits designed by the, separately packaged, control processors are custom designed to provide logic signals, select and address signals, for 1M DRAM devices.

A subsequent enhanced product might offer a 4M Byte DRAM card which poses a problem in that the logic signals provided are incapable of driving the denser card. This problem has been solved by the provision of a DRAM module package containing one or more logic signal driver modules to redrive those signals intended to be coupled to the new 4M Byte card.

The application of such independent signal driver modules is described in the representative prior art such as the article "Extended Data Bus with Direction and Enable Control Features," by H.C. Lin et al, IBM Technical Disclosure Bulletin, Vol. 26, No. 10A, March 1984, pp.5147-5152 or in US Patent 4,598,410 to Smith et al or in US Patent 4,698,826 to Denhez et al. Because of the adaptation of the system to accommodate increased memory capacity, usually in the form of a circuit module or card designed to fit a physically constrained area, a problem is presented in how to physically place the increased capacity memory modules plus and one or more redriver modules in the space designed for memory modules alone. In addition, the requirement for separate redriver modules increases the cost of adding additional memory capacity by the cost of the redriver modules in addition to any increase due to the new memory modules and their associated packaging.

EP-A-0 325 078 by the same applicant discloses a mechanism for error detection and reporting on a synchronous bus. The subject mechanism is implemented in a passive device (30) inserted on a synchronous bus (1-1,1-2), linking two devices (2,4). The bus comprises data lines (6,...,24) onto which data are transferred between the two devices under control of tag lines and clock signals, which are companion of the transferred data. It allows errors to be detected and the failing device to be identified and the error signals to be reported in a pseudo synchronous way on an error bus, thanks to error detection and a reporting logic circuit and a pseudo syncho timing circuit. The passive device (30) comprises redriver means (32) connected to at least one (24-1) of said data lines from said first device (2), the output of said redriver means carrying the redriven signal (24-2) of said at least one data line and supplying the redriven signal to one of the inputs of said second device (4).

The invention is specified in claim 1. It enables the addition of modules having similar function, particularly in the case of memory modules, to a system without concern for physical space constraints or additional cost. In accordance with the present invention, additional modules having at least some common input signal requirements, can be provided without concern for physical space restraints or additional cost. This objective is achieved by providing within the logic or DRAM device the capability of redriving one or more input signals intended for others of the added modules. If a sufficient number of modules are required, the number of redrivers per added module can be optimized at one redriver per module.

It is an object of the invention to provide a plurality of similar semiconductor devices, each requiring a common subset of input signals, with at least one input signal driver circuit responsive to an input signal and for providing an output signal coupled a plurality of devices having the same input signal requirements. That is, for each of a plurality of like-function devices, there is provided a redriver circuit responsive to an input signal which provides an output signal coupled to all of the plurality of like-function devices.

Another object of the invention is to reduce the cost of providing increased capacity of semiconductor subassemblies (cards) without the provision of additional semiconductor modules for signal redrive. These objectives and advantages will be apparent from the detailed description of the invention.
- Fig.1: is a schematic representation of an expansion memory package of the invention showing the relationship between the input signals applied to the package and the connections to the plurality of memory modules.
- Fig.2: is a schematic circuit representation of the redriver of the invention as embodied within a single DRAM module.
- Fig.3: is a detailed circuit diagram of a typical input receiver circuit for receiving the logic signals applied to the redriver of the invention.
- Fig.4: is a detailed circuit diagram of a typical off-chip driver for providing the output signals of the invention.

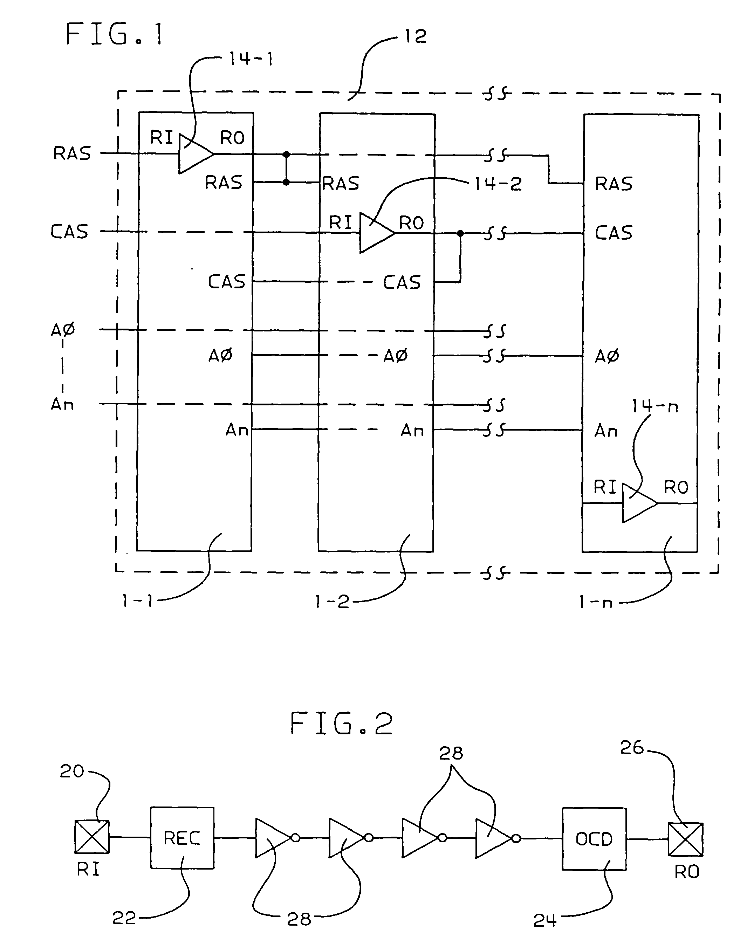

Referring to Fig.1, an embodiment of the invention is shown in the form of an assembly of a plurality of semiconductor devices 1-1, 1-2 ...1-n mounted on a common substrate 12. The devices are representative of any of a number of devices in which a plurality of devices requiring at least some common input signals are required by a particular application. In the preferred embodiment, these semiconductor devices may be memory modules mounted in a SIMM or SIP configuration. As shown each memory device requires a number of input signals such as row access strobe RAS, column access strobe CAS, address inputs A0...An, as well as read/write inputs, one or more data inputs and driver devices, to all of the memory devices 1-1...1-n. In the configuration of the invention, it is a primary feature to provide, as a portion of the circuitry on each semiconductor device, an input signal redriver or buffer circuit 14-1, 14-2... 14-n. Each memory device contains one or more isolated redriver circuits 14, each having an associated redrive input RI and redrive output RO. As shown in Fig.1, each memory device includes one redriver circuit, although any number can be provided. The RAS input signal is applied to the RI input of device 1-1, while the output RO of redriver 14-1 is coupled, via the subassembly wiring to the RAS input of each of the memory devices, including device 14-1. In a similar manner, the input CAS is initially applied to the RI input of device 1-2 and its output RO is coupled to the CAS input of each of the memory devices.

In the design of the individual memory devices 1, the number of redriver circuits depends upon the total number of input signals anticipated in the multi-device subassembly 12. Where the number of input signals is less than the number of devices, one or more redriver circuits may be left unconnected, as shown in device 1-n.

Fig.2 illustrates a typical schematic representation of a single redriver circuit. Included are an input pad 20, a receiver circuit 22, an off-chip driver (OCD) circuit 24, an output pad 26, and one or more inverter driver circuits 28. The number of inverter driver circuits 28 required, if any, depends on the particular technology and ability to obtain an adequate signal level required by the off-chip driver 24. In the preferred embodiment, it was the designer's choice to simplify the design of the receiver 22 and the OCD, these circuits were designed to be substantially identical to the individual receiver and OCD circuits already required by the memory devices when the redriver feature is not used. Therefore a total of four inverter driver circuits 28 were required, each being capable of driving a higher output load.

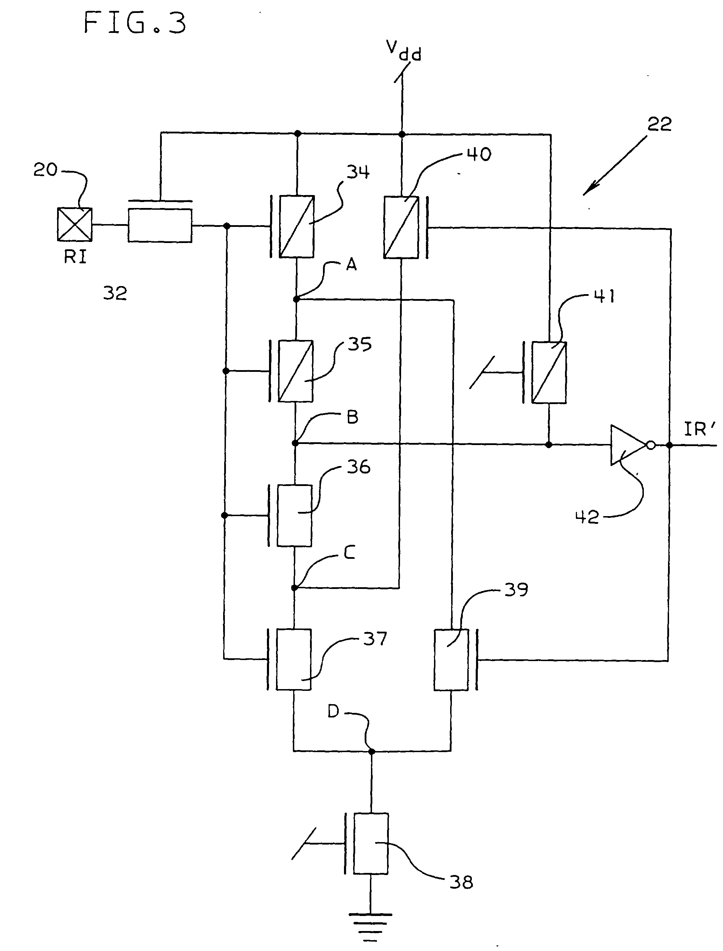

Referring now to Fig.3, there is shown the detailed circuit schematic of a receiver circuit 22 useful in implementing the invention. The receiver comprises a level sensitive CMOS embodiment of a Schmitt trigger circuit. Briefly, the circuit operates in response to the signal level provided on device input pad 22 which is applied through device 32 to the gates of devices 34, 35, 36 and 37. When the input signal is high devices 34 and 35 are biased off and devices 36 and 37 are biased on. Device 32 is permanently biased on by having its gate coupled to supply potential Vdd. Voltage node B coupled to the input of inverter 42 is held low forcing the Intermediate Redrive node IR' high.

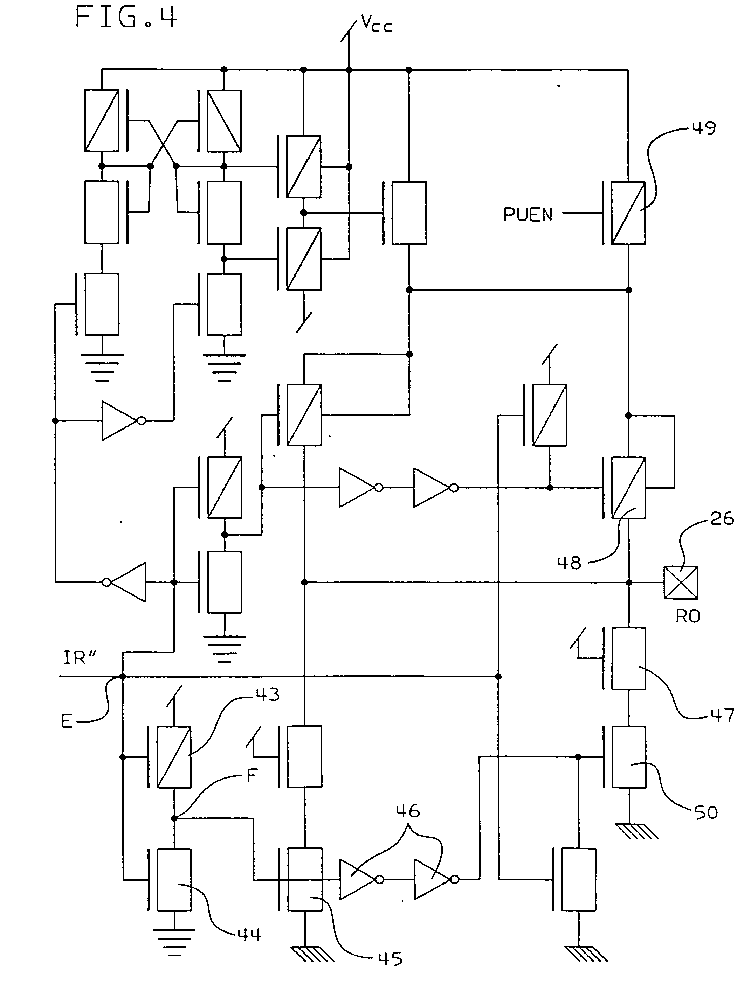

Fig.4 is a detailed circuit schematic of the OCD circuit of the preferred embodiment. Briefly, the OCD circuit operates as follows. Because the internal circuitry uses a drain supply voltage Vdd of 3 volts and the OCD requires an output level Vcc of 5 volts a conversion of levels is required to be performed by the OCD. The internal redriver signal IR" received by the OCD is applied to the voltage node E and to the gates of devices 43 and 44 which form an inverter, driving node F. The signal at node F, in turn, is applied through inverters 46 to the gate of pull-down device 50 which drives the redriver output signal RO on device pad 26. The p-type pull-up device 49 has its gate coupled to a Power Up Enable signal PUEN generated within the memory device which prevents the output terminals of the device, such as redriver output RO from drawing unusually large amounts of current during power up sequencing when power is initially applied to the semiconductor subassembly or card. The article "5-Volt Signal Level Shifter in a 3-Volt Circuit" IBM

Technical Disclosure Bulletin, Vol. 32, No. 7, pages 454-455, December 1989, describes the circuit in greater detail.

Thus, in accordance with the invention it has been shown that the performance provided by enhanced semiconductor technology need not be compromised by a requirement of additional space or circuit modules. With respect to the preferred embodiment, the following improvements are achieved by implementation of the features of the invention. Simultaneous switching of signal levels is distributed across the entire subassembly or card. The net switching delays are reduced, as is the net load. Area required for a discrete buffer/driver module is not required. Impedance matching between buffer and receiving devices is not a concern. The performance of the redrive circuitry will track with that of its associated functional devices. All generational improvements made in the functional device technology will be translated into subassembly or card level improvements.

## Claims

1. Input signal redriver system for a semiconductor assembly (12) comprising a plurality of discrete semiconductor devices (1-1...1-n) having a plurality of input terminals, each semiconductor device being responsive to at least one input signal (RAS, ..) common to at least some of the devices, said redriver system further comprising:
redriver means (14-1...14-n) responsive to at least said one input signal (RAS) applied to said assembly (12), said redriver means being an integral part of the circuitry associated with at least one of said semiconductor devices (1-1...1-n), and
the output (R0) of said redriver means being applied as said one input signal (RAS) to the corresponding input terminal of said at least some of said semiconductor devices.

2. The semiconductor assembly of claim 1 wherein said assembly (12) includes at least one semiconductor memory module.

3. The semiconductor assembly of claim 2 wherein said semiconductor memory module comprises at least two semiconductor memory devices (1-1...1-n).

4. The semiconductor assembly of claim 1 wherein at least one of said semiconductor devices (1-1, ...) comprises a semiconductor memory device.

5. The semiconductor assembly of claim 1 wherein said assembly includes at least one logic device.

## Patentansprüche

1. Eingangssignal-Zusatzverstärkersystem für eine Halbleiter-Baugruppe (12), welche eine Vielzahl diskreter Halbleiter-Bauelemente (1-1 ... 1-n) enthält, die eine Vielzahl Eingangsanschlüsse besitzen, wobei jedes Halbleiter-Bauelement auf mindestens ein Eingangssignal anspricht (RAS, ...) das zumindest für einige der Bauelemente gleich ist, wobei das Zusatzverstärkersystem weiterhin aufweist:
Zusatzverstärkermittel (14-1 ... 14-n), die auf mindestens ein Eingangssignal (RAS) reagieren, das an die Baugruppe (12) angelegt wird, wobei die Zusatzverstärkermittel einen integralen Bestandteil der Schaltung bilden, die zumindest einem der Halbleiter-Bauelemente (1-1 ... 1-n) entspricht; und
wobei der Ausgang (RO) der Zusatzverstärkermittel als das Eingangssignal (RAS) an die entsprechenden Eingangsanschlüsse der zumindest einigen der Halbleiter-Bauelemente angelegt wird.

2. Halbleiter-Baugruppe gemäß Anspruch 1, wobei die Baugruppe (12) mindestens einen Halbleiter-Speichermodul aufweist.

3. Halbleiter-Baugruppe gemäß Anspruch 2, wobei das Halbleiter-Speichermodul mindestens zwei Halbleiter-Speicherbauelemente (1-1, ..., 1-n) aufweist.

4. Halbleiter-Baugruppe gemäß Anspruch 1, wobei mindestens eines der Halbleiter-Bauelemente (1-1, ...) ein Halbleiter-Speicherbauelement aufweist.

5. Halbleiter-Baugruppe gemäß Anspruch 1, wobei die Baugruppe mindestens ein logisches Bauelement enthält.

## Revendications

1. Système de réadaptation de signal d'entrée destiné à un montage à semi-conducteurs (12) comprenant une pluralité de dispositifs à semi-conducteurs discrets (1-1...1-n) possédant une pluralité de bornes d'entrée, chaque dispositif à semi-conducteurs répondant à au moins un signal d'entrée (RAS, ...) commun à au moins certains des dispositifs, ledit système de réadaptation comprenant en outre :
un moyen de réadaptation (14-1...14-n) répondant au moins audit un signal d'entrée (RAS) appliqué audit montage (12), ledit moyen de réadaptation faisant partie intégrante du circuit associé avec au moins l'un desdits dispositifs à semi-conducteurs (1-1...1-n), et
la sortie (R0) dudit moyen de réadaptation étant appliquée comme étant ledit un signal d'entrée (RAS) à la borne d'entrée correspondante desdits au moins certains desdits dispositifs à semi-conducteurs.

2. Montage à semi-conducteurs selon la revendication 1, dans lequel ledit montage (12) comprend au moins un module mémoire à semi-conducteurs.

3. Montage à semi-conducteurs selon la revendication 2, dans lequel ledit module mémoire à semi-conducteurs comprend au moins deux dispositifs mémoire à semi-conducteurs (1-1...1-n).

4. Montage à semi-conducteurs selon la revendication 1, dans lequel au moins un desdits dispositifs à semi-conducteurs (1-1, ...) comprend un dispositif mémoire à semi-conducteurs.

5. Montage à semi-conducteurs selon la revendication 1, dans lequel ledit montage comprend au moins un dispositif logique.
